# EUROPEAN PATENT APPLICATION

(11) **EP 1 713 125 A1**
(43) Date of publication of application: **18.10.2006**
(21) Application number: 06114148.7
(22) Date of filing: 21.05.2002
(51) Int. Cl.: H01L 27/08

(54) **On chip inductive structure**

(30) Priority: 24.05.2001 US 292912 P
(62) Divisional of application: 02253571.0
(71) Applicant: Nokia Corporation, 02150 Espoo (FI)
(72) Inventor: Nielsen, John, 3400 Hillerød (DK)
(74) Representative: Read, Matthew Charles

(57) **Abstract**

An on-chip inductive structure, such as the load inductors of a push-pull amplifier, comprises a substrate (20) and first and second inductors (4, 5) connected in series and formed on the substrate (20). The inductors (4, 5) spiral in opposite senses about a common centre in substantially the same plane.

## Description

The present invention relates to an on-chip inductive structure comprising a substrate and first and second inductors connected in series and formed on the substrate.

For many years, inductive components for radio circuits operating at VHF and UHF frequencies were made by forming copper wire into self-supporting helices. However, the development of printed circuit board techniques and subsequently the desire to incorporate inductors into integrated circuits has led to inductor designs employing planar spiral forms.

Certain inductor designs require two coils, wound in the same sense, to be connected in series and share a common magnetic circuit.

It is an aim of the present invention to provide an on-chip inductive device with good matching between inductors in respect of inductance resistance and parasitic capacitance.

An inductive structure according to the present invention is characterised in that the inductors spiral in opposite senses about a common centre in substantially the same plane.

Preferably, first inductor alternately passes over and under the second inductor as it spirals about said centre. More preferably, the first inductor passes under the second inductors in a trough formed in a dielectric layer on the substrate. Still more preferably, the spiralling in of the inductors is caused by inward path transitions where the first inductor passes over or under the second inductor.

The turns of inductors may be substantially rectangular. Preferably, the turns are substantially square.

Preferably, the device exhibits at least one degree of mirror symmetry, to a substantial extent, along a line in said plane. In a preferred embodiment, the symmetry is only disturbed by the crossings of the spirals which require one or both of the spirals to digress out of the main plane of the device.

A push-pull amplifier may have load inductors which constitute a structure according to the present invention. In this case, the inductive structure may include output signal paths following peripheral routes around respective halves thereof.

An embodiment of the present invention will now be described, by way of example, with reference to the accompanying drawings, in which:
Figure 1 is a circuit diagram illustrating push-pull amplifier having load inductors according to the present invention;
Figure 2 is a simplified plan view of an inductive structure according to the present invention; and
Figure 3 is a vertical sectional view of part of the inductive structure of Figure 2.

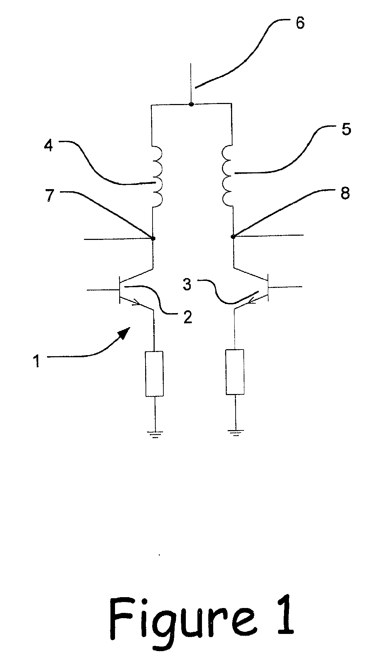

Referring to Figure 1, a push-pull amplifier 1 comprises a first and second transistors 2, 3 and a pair of load inductors 4, 5 connected between the collectors 7, 8 of respective transistors 2, 3 and a positive voltage line 6. The amplifier's output is taken between the collectors of the transistors 2, 3.

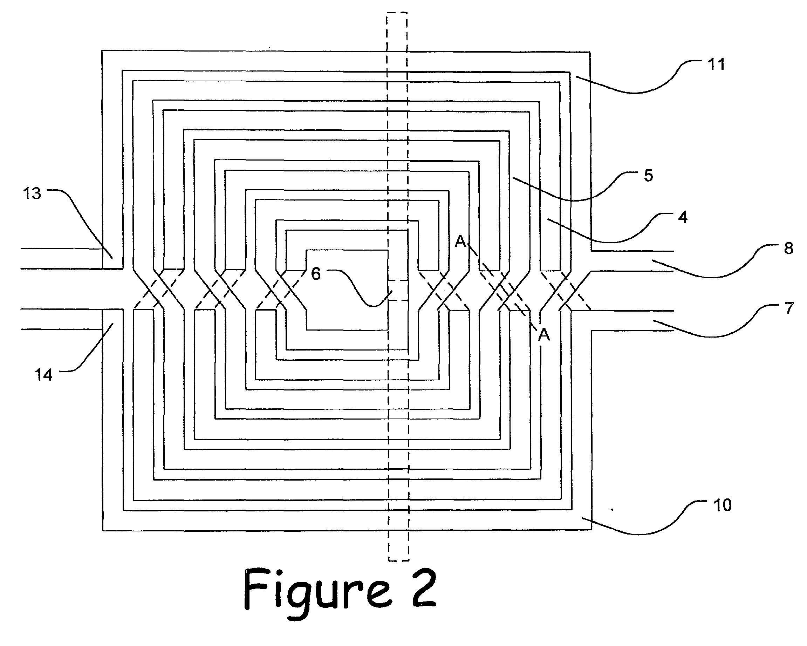

Referring to Figure 2, the load inductors 4, 5 together form a generally square inductive structure. The inductors' ends, which are connected to the collectors 7, 8, are close together centrally on one side of the structure. The output is taken by peripheral paths 10, 11 around the load inductors 4, 5 to points 13, 14 opposite the collector nodes.

The inductors 4, 5 spiral in opposite senses to the centre of the inductive structure. The spiral paths of the inductors 4, 5 are squared, stepping in twice in each turn at points 180° apart. These points are located on an axis extending between the collector connections and the output points 13, 14. Figure 2 shows 3 turns in each of the inductors 4, 5 and it will be appreciated that there may be many more in practice.

The paths of the inductors 4, 5 cross each other where they step in. On the transistor side of the inductive structure, the first inductor 4 passes under the second inductor 5 and, on the other side of the inductive structure, the second inductor passes 5 passes under the first inductor 4.

The positive voltage line 6 passes under the inductive structure and is connected to the central point where the first and second inductors 4, 5 meet.

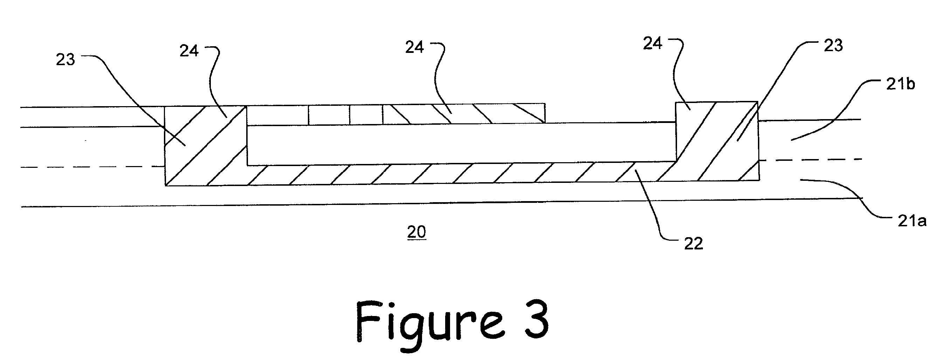

Referring to Figure 3, the inductive structure is formed on a silicon substrate 20. During manufacture, a first SiO₂ layer 21a is formed on the substrate 20 and then partially etched through to form troughs for the underpasses of the inductors 4, 5 and the positive voltage line 6. Metal 22, e.g. Al or Cu, is deposited in the troughs and a second SiO₂ layer 21b is formed over the metal 22 and the first SiO₂ layer 21a. The second SiO₂ layer 21b is then etched to form vias at either end of the troughs and metal 23 is deposited in the vias. Finally, metal 24 is deposited to connect the vias to form the inductors 4, 5 and the peripheral paths 10, 11.

## Claims

1. An on-chip inductive structure comprising a substrate (20) and first and second inductors (4, 5) connected in series and formed on the substrate (20), **characterised in that** the inductors (4, 5) spiral in opposite senses about a common centre in substantially the same plane.

2. A structure according to claim 1, wherein first inductor (4) alternately passes over and under the second inductor (5) as it spirals about said centre.

3. A structure according to claim 2, wherein the first inductor (4) passes under the second inductor (5) in a trough formed in a dielectric layer (21a, 21b) on the substrate (20).

4. A structure according to claim 2 or 3, wherein the spiralling in of the inductors (4, 5) is caused by inward path transitions where the first inductor (4) passes over or under the second inductor (5).

5. A structure according to any preceding claim, wherein the turns of inductors are substantially rectangular.

6. A structure according to claim 5, wherein said turns are substantially square.

7. A structure according to any preceding claim, exhibiting at least one degree of mirror symmetry, to a substantial extent, along a line in said plane.

8. A push-pull amplifier having load inductors (3, 4) which constitute a structure according to any preceding claim.

9. A push-pull amplifier according to claim 8, wherein the inductive structure includes output signal paths (13, 14) following peripheral routes around respective halves thereof.
